# EUROPEAN PATENT APPLICATION

(11) **EP 2 677 550 A1**
(43) Date of publication of application: **25.12.2013**
(21) Application number: 13755908.4
(22) Date of filing: 25.02.2013
(51) Int. Cl.: H01L 31/04

(54) **CONDUCTIVE PASTE APPLYING MECHANISM AND CELL WIRING DEVICE**

(30) Priority: 29.02.2012 JP 2012043788
(71) Applicant: NPC Incorporated, Arakawa-ku Tokyo 116-0003 (JP)
(72) Inventor: MATSUMOTO Kanichiro, Matsuyama-shi Ehime 791-8044 (JP); TAKECHI Hiroshi, Matsuyama-shi Ehime 791-8044 (JP); WATANABE Shin, Matsuyama-shi Ehime 791-8044 (JP)
(74) Representative: Roberts, Gwilym Vaughan
(86) International application number: PCT/JP2013/054729
(87) International publication number: WO 2013/129301

(57) **Abstract**

A conductive paste applying mechanism 14 of an embodiment of the present invention has: a swing unit 140 configured to hold a solar cell 1 so that a surface of the solar cell 1 is positioned on a holding surface; and an applying unit 142 configured to apply a conductive paste on first and second faces of the solar cell 1. In a period since the conductive paste is applied on the first face until the conductive paste is applied on the second face, the swing unit 140 swings around the swing axis as a center while holding the solar cell 1. There is an offset in the perpendicular direction between the swing axis and the holding surface.

## Description

### Technical Field

An embodiment of the present invention relates to a conductive paste applying mechanism and a cell wiring apparatus and, more particularly, relates to a conductive paste applying mechanism and a cell wiring apparatus which are used for manufacturing a solar cell string.

### Background Art

In recent years, solar cells using unlimited nature energy are being spread worldwide. One of solar cells being spread is a crystalline solar cell module. The crystalline solar cell module is manufactured by sandwiching a solar cell string obtained by connecting a number of solar cells in series by protection members, glass, or the like via a sealing member (that is, by laminating the string).

A solar cell string is manufactured using a conductive tape as an adhesive material in recent years. The conductive tape has an advantage that the solar cells can be adhered at temperature lower than that in the case of using solder. For example, patent literature 1 discloses a solar cell string manufacturing apparatus for manufacturing a solar cell string by pressure-bonding a conductive tape.

### Summary of Invention

### Technical Problem

A conventional cell wiring apparatus has, however, a problem such that the size of the cell wiring apparatus is large since the size of each of an adhering mechanism for adhering a conductive tape and a pressure-bonding mechanism for pressure-bonding the tape is large.

The present invention has been achieved in consideration of the above problem and an object to be achieved by the present invention is to reduce the size of an apparatus for manufacturing a solar cell string.

### Solution to Problem

A conductive paste applying mechanism of an embodiment of the present invention has: a swing unit configured to hold a solar cell so that a surface of the solar cell is positioned on a holding surface; and an applying unit configured to apply a conductive paste on a first face and a second face of the solar cell. In a period since the conductive paste is applied on the first face until the conductive paste is applied to the second face, the swing unit swings around a swing axis as a center while holding the solar cell, and there is an offset in the perpendicular direction between the swing axis and the holding surface.

### Advantageous Effects of Invention

According to the present invention, the size of an apparatus for manufacturing a solar cell string can be reduced.

### Brief Description of Drawings

FIG. 1 is a schematic diagram of a crystalline solar cell string S of an embodiment of the present invention.
FIG. 2 is a block diagram illustrating the configuration of a cell wiring apparatus 10 of the embodiment.
FIG. 3 is a schematic diagram illustrating the configuration of a conductive paste applying mechanism 14 of the embodiment.
FIG. 4 is a schematic diagram illustrating the configuration of a swing unit 140 and an applying unit 142 of the embodiment.
FIG. 5 is a schematic diagram illustrating the operation of the conductive paste applying mechanism 14 of the embodiment.

### Description of Embodiments

An embodiment of the invention will be described with reference to the drawings.

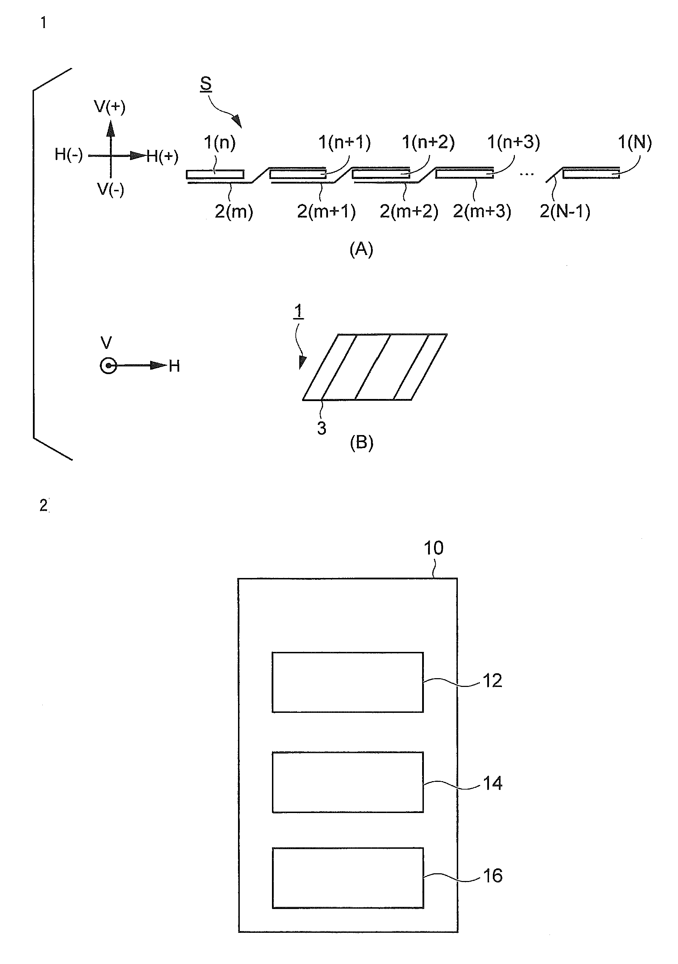

A crystalline solar cell string of the embodiment will be described. FIGS. 1A and 1B are schematic diagrams of a crystalline solar cell string S of the embodiment. In FIG. 1, (A) illustrates a section of the crystalline solar cell string S and (B) illustrates a light reception face of a solar cell 1.

As illustrated in (A) IN FIG. 1, the crystalline solar cell string S has a plurality of solar cells 1(n) (n = 1 to N (N is an integer of two or larger) and tabs 2(m) (m = 1 to N-1).

The plurality of solar cells 1(n) is disposed at predetermined intervals in the H direction (hereinbelow, called "horizontal direction) (A) and (B) in FIG. 1. As illustrated (B) in FIG. 1, a plurality of bus bar electrodes 3 are formed on each of the surfaces (the light reception face and a non-light-reception face) of the solar cell 1.

As illustrated in (A) IN FIG. 1, the tab 2 is a wiring material which connects the non-light-reception face (that is, the face on the V(-) side in (A) IN FIG. 1) of a solar cell 1(n) with the light reception face (that is, the face on the V(+) side in (A) IN FIG. 1) of a solar cell 1(n+1) adjacent to the solar cell 1(n). The tab 2 is disposed between the solar cell 1(n) and the solar cell 1(n+1).

A cell wiring apparatus of the embodiment will be described. A cell wiring apparatus 10 is a device which manufactures the crystalline solar cell string S (A) and (B) in FIG. 1. FIG. 2 is a block diagram illustrating the configuration of the cell wiring apparatus 10 of the embodiment.

As illustrated in FIG. 2, the cell wiring apparatus 10 has a cell disposing mechanism 12, a conductive paste applying mechanism 14, and an adhering mechanism 16.

The cell disposing mechanism 12 is a mechanism for taking the plurality of solar cells 1(n) out from magazines and for disposing them in predetermined positions. Concretely, the cell disposing mechanism 12 positions the plurality of solar cells 1(n) carried in a predetermined carriage direction in the cell wiring apparatus 10 and disposes the plurality of solar cells 1(n) based on the result of the positioning.

The conductive paste applying mechanism 14 is a mechanism for applying conductive paste on the bus bar electrodes 3 formed on the surface of the solar cell 1.

The conductive paste is a paste-state material in which conductive particles are mixed in a thermoset resin. The conductive paste has an advantage such that, like a conductive tape, it can adhere solar cells at temperature lower than that of solder and, even it is applied discontinuously (for example, in dots), an adhering effect equivalent to that of a conductive tape is obtained.

The adhering mechanism 16 is a mechanism for adhering the solar cell 1(n), the solar cell 1(n+1), and the tab 2 (that is, performing an adhering process on the solar cells on which the conductive paste is applied). For example, the adhering mechanism 16 heats the solar cells 1(n) and 1(n+1) and the tab 2 by using a heat source (such as hot air, an infrared lamp, or an induction heater). By the heating, the conductive particles included in the conductive paste react. As a result, the solar cells 1(n) and 1(n+1) and the tab 2 are adhered.

When the processes of the cell disposing mechanism 12 to the adhering mechanism 16 are finished, the first face of the solar cell 1(n) and the second face of the solar cell 1(n+1) are connected to each other by the tab 2. As a result, the crystalline solar cell string S as illustrated in (A) IN FIG. 1 is obtained.

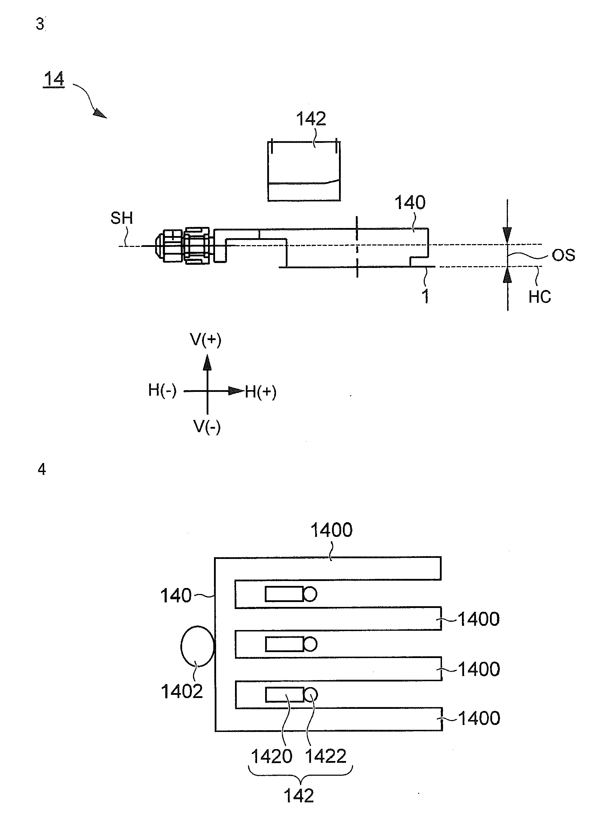

The configuration of the applying mechanism of the embodiment will be described. FIG. 3 is a schematic diagram illustrating the configuration of the conductive paste applying mechanism 14 of the embodiment.

As illustrated in FIG. 3, the conductive paste applying mechanism 14 has a swing unit 140 and an applying unit 142. The swing unit 140 and the applying unit 142 can move in the V(+) direction (hereinbelow, called "upward movement") and in the V(-) direction (hereinbelow, called "downward movement") (that is, move in perpendicular direction with respect to the carrying direction of the solar cell 1) and move in the H(+) and H(-) directions (that is, the move in horizontal direction with respect to the carrying direction of the solar cells 1).

The swing unit 140 is a module which holds the solar cell 1 so that the surface of the solar cell 1 is positioned on a holding face HC. For example, the swing unit 140 holds the solar cell 1 by adsorbing the solar cell 1 moving in the H(+) direction. The swing unit 140 can swing around a swing axis SH as a center. Between the swing axis SH and the holding face HC, there is an offset OS in the perpendicular direction (that is, the V(+) direction or the V(-) direction). That is, the swing axis SH is deviated in the perpendicular direction from the holding face only by the offset OS.

The applying unit 142 is a module which applies the conductive paste on the bus bar electrodes 3 formed on the surface of the solar cell 1.

The swing unit of the embodiment will be described. FIG. 4 is a schematic diagram illustrating the configuration of the swing unit 140 and the applying unit 142 of the embodiment.

As illustrated in FIG. 4, the swing unit 140 has a plurality of arms 1400 and a swing driving unit 1402. The arms 1400 are provided at intervals so as not to interfere with the applying units 142.

An adsorption hole (not illustrated) is provided in the under face of the arm 1400. The arm 1400 is connected to an adsorption controller (for example, a vacuum ejector) (not illustrated). The arm 1400 holds the solar cell 1 by adsorption in accordance with control of the adsorption controller.

The applying unit 142 has a dispenser 1420 and a syringe 1422.

The dispenser 1420 is a module of injecting the conductive paste ejected from the syringe 1422 to the bus bar electrode 3.

The syringe 1422 is a module of ejecting the conductive paste to the dispenser 1420.

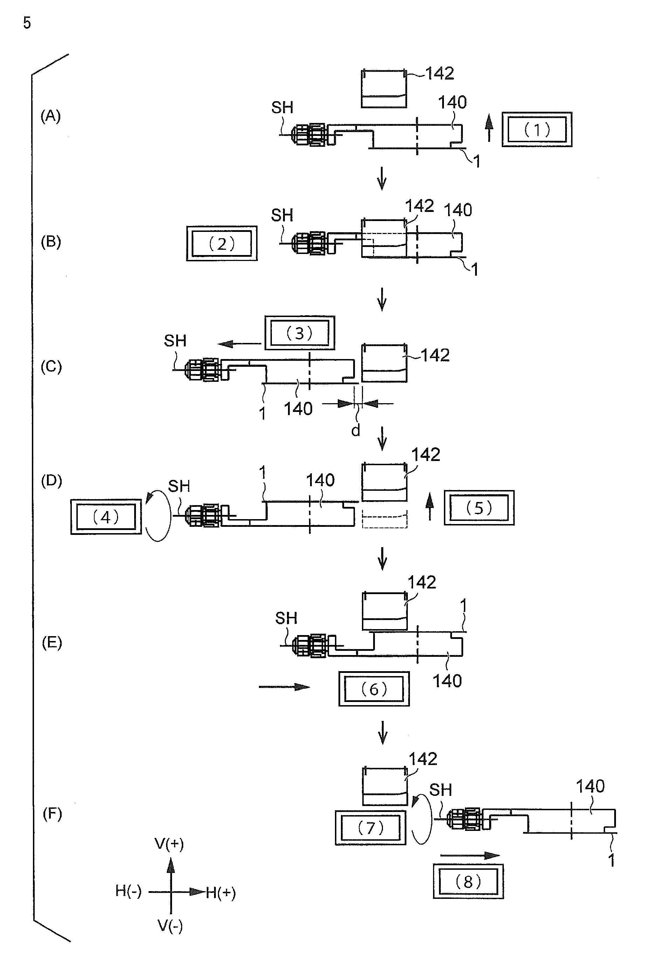

The operation of the applying mechanism of the embodiment will be described. FIGS. 5A to 5F are schematic diagrams illustrating the operation of the conductive paste applying mechanism 14 of the embodiment.

When the processes of the cell disposing mechanism 12 are finished, as illustrated (A) in FIG. 5, the swing unit 140 holds the solar cell 1 by adsorption. Subsequently, the swing unit 140 moves in the V(+) direction (hereinbelow, described as "moves upward") while holding the solar cell 1 so that the light reception face of the solar cell 1 faces the V(+) side (1). On the other hand, the applying unit 142 waits in a predetermined stop position (for example, a position apart in the V(-) direction from a predetermined initial position only by predetermined distance) while the swing unit 140 moves upward.

Subsequently, as illustrated (B) in FIG. 5, by operating the dispenser 1420, application of the conductive paste is started (2).

Subsequently, as illustrated (C) in FIG. 5, the swing unit 140 moves in the H(-) direction. On the other hand, the dispenser 1420 applies the conductive paste on the bus bar electrodes 3 formed on the light reception face of the solar cell 1 while the swing unit 140 moves in the H(-) direction (3). The conductive paste is continuously (for example, in linear shape) or discontinuously (for example, in dots shape) applied. When the application of the conductive paste is finished, the swing unit 140 stops in a position apart from the applying unit 142 only by predetermined direction "d" in the H(-) direction.

Subsequently, as illustrated (D) in FIG. 5, the swing unit 140 swings around the swing axis SH as a center (4). As a result, the non-light-reception face of the solar cell 1 faces in the V(+) direction. On the other hand, the applying unit 142 moves upward in the V(+) direction and returns to the initial position while the swing unit 140 swings (5).

Subsequently, the applying unit 142 starts application of the conductive paste in a manner similar to (B) in FIG. 5. When application of the conductive paste is started, as illustrated (E) in FIG. 5, the swing unit 140 moves in the H(+) direction. On the other hand, the dispenser 1420 applies the conductive paste on the bus bar electrodes 3 formed on the non-light-reception face of the solar cell 1 while the swing unit 140 moves in the H(+) direction (6).

Subsequently, as illustrated (F) in FIG. 5, after completion of the application of the conductive paste, the swing unit 140 swings around the swing axis SH as a center (7) and moves in the V(-) direction, thereby carrying the solar cell 1 to the adhering mechanism 16 in a state where the light reception face of the solar cell 1 faces in the V(+) direction (8). When the solar cell 1 reaches the adhering mechanism 16, the swing unit 140 mounts the solar cell 1 on the adhering mechanism 16.

In the embodiment, the cell wiring apparatus 10 has the conductive paste applying mechanism 14. The size of the conductive paste applying mechanism 14 is smaller than that of a mechanism using a conductive tape.

Consequently, the size of the mechanism using an adhesive material can be reduced. As a result, the size of the device of manufacturing the solar cell string S (that is, the cell wiring apparatus 10) can be also reduced.

If there is no offset OS in the perpendicular direction between the swing axis SH and the holding face HC of the swing unit 140, after application of the conductive paste on the bus bar electrodes 3 formed on the surfaces (the light reception face and the non-light-reception face) of the solar cell 1, the process of stopping the swing unit 140 or the applying unit 142 and further moving the applying unit 142 upward from the initial position or moving the swing unit 140 downward is necessary in order to avoid interference between the swing unit 140 (particularly, the swing driving unit 1402) and the applying unit 142. In this case, the throughput of the solar cell manufacturing process (particularly, the manufacturing process of the solar cell string S) decreases and the size of the conductive paste applying mechanism 14 increases.

In contrast, according to the embodiment, since there is the offset OS in the perpendicular direction between the swing axis SH and the holding face HC of the swing unit 140, no interference occurs between the swing unit 140 (particularly, the swing driving unit 1402) and the applying unit 142. That is, it is unnecessary to stop the swing unit 140 or the applying unit 142 in order to avoid the interference. Consequently, the throughput of the solar cell manufacturing process (particularly, the manufacturing process of the solar cell string S) can be improved and the size of the conductive paste applying mechanism 14 can be further reduced.

Furthermore, according to the embodiment, to avoid the interference, it is unnecessary to move the swing unit 140 or the applying unit 142 to the stop position. Consequently, the size of the conductive paste applying mechanism 14 can be further reduced.

Furthermore, according to the embodiment, the conductive paste can be discontinuously applied. By this manner, the use amount of the conductive paste can be reduced. As a result, the cost of the conductive paste can be reduced.

A modification of the embodiment will be described.

In the modification of the embodiment, in the process of (C) in FIG. 5, the swing unit 140 moves in the H(-) direction and, in addition, the applying unit 142 moves in the H(+) direction (that is, the direction opposite to the movement direction of the swing unit 140).

Furthermore, in the modification of the embodiment, in the process of (E) in FIG. 5, the swing unit 140 moves in the H(+) direction and, in addition, the applying unit 142 moves in the H(-) direction (that is, the direction opposite to the movement direction of the swing unit 140).

According to the modification of the embodiment, at the time of applying the conductive paste, the swing unit 140 and the applying unit 142 are moved in directions opposite to each other in the horizontal directions. By the above, the throughput can be further improved than the throughput in the embodiment.

In the embodiment, the number of the arms 1400 and the number of the applying units 142 are variable. For example, the number of the arms 1400 and the number of the applying units 142 depend on the number of the bus bar electrodes 3 on which the conductive paste is to be applied.

The present invention is not limited to the above-described embodiments and is embodied by modifying the components without departing from the gist. By properly combining a plurality of components disclosed in the foregoing embodiments, various inventions can be formed. For example, some components may be eliminated from all of the components described in the foregoing embodiments. Further, components in different embodiments may be properly combined.

### Citation List

### Patent Literature

Patent Literature 1: Japanese Patent Application Laid-Open (JP-A) No. 2012-15483

### Reference Signs List

- 1: solar cell
- 2: tab
- 3: bus bar electrode
- 10: cell wiring apparatus
- 12: cell wiring mechanism
- 14: conductive paste applying mechanism
- 140: swing unit
- 1400: arm
- 1402: swing driving unit
- 142: applying unit
- 1420: dispenser
- 1422: syringe
- 16: adhering mechanism
- S: crystalline solar cell string

## Claims

1. A conductive paste applying mechanism comprising:
a swing unit configured to swing around a swing axis as a center while holding a solar cell so as to position a surface of the solar cell on a holding surface; and
an applying unit configured to apply a conductive paste on a first face and a second face of the solar cell, wherein
there is an offset in the perpendicular direction between the swing axis and the holding face,
the swing unit moves in a first horizontal direction,
the applying unit moves in a second horizontal direction opposite to the first horizontal direction and applies the conductive paste on the first face,
after the conductive paste is applied on the first face, the swing unit swings around the swing axis as a center while holding the solar cell and moves in the second horizontal direction, and
after the swing unit swings, the applying unit moves in the first horizontal direction and applies the conductive paste on the second face.

2. The conductive paste applying mechanism according to claim 1, wherein
the swing unit has a plurality of arms, and
the arms are provided at intervals so as not to interfere with the applying unit.

3. A cell wiring apparatus comprising:
a cell disposing mechanism configured to dispose solar cells;
a conductive paste applying mechanism configured to apply a conductive paste on the solar cells; and
an adhering mechanism configured to perform an adhering process on the solar cells on which the conductive paste is applied,
wherein
the conductive paste applying mechanism comprises:
a swing unit configured to swing around a swing axis as a center while holding a solar cell so as to position a surface of the solar cell on a holding surface; and
an applying unit configured to apply the conductive paste on a first face and a second face of the solar cell,
there is an offset in the perpendicular direction between the swing axis and the holding face,
the swing unit moves in a first horizontal direction,
the applying unit moves in a second horizontal direction opposite to the first horizontal direction and applies the conductive paste on the first face,
after the conductive paste is applied on the first face, the swing unit swings around the swing axis while holding the solar cell and moves in the second horizontal direction, and
after the swing unit swings, the applying unit moves in the first horizontal direction and applies the conductive paste on the second face.

4. The cell wiring apparatus according to claim 3, wherein
the swing unit has a plurality of arms, each of the arms being provided at intervals so as not to interfere with the applying unit.
